(19) Europäisches Patentamt
European Patent Office
Office européen des brevets

(11) Veröffentlichungsnummer: **0 118 960**
**A2**

(12) # EUROPÄISCHE PATENTANMELDUNG

(21) Anmeldenummer: **84200337.8**

(22) Anmeldetag: **09.03.84**

(51) Int. Cl.³: **H 04 N 9/535**
H 03 K 13/00

(30) Priorität: **14.03.83 DE 3309080**

(43) Veröffentlichungstag der Anmeldung: **19.09.84 Patentblatt 84/38**

(84) Benannte Vertragsstaaten: **DE FR GB IT**

(71) Anmelder: **Philips Patentverwaltung GmbH**
**Billstrasse 80**
**D-2000 Hamburg 28(DE)**

(84) Benannte Vertragsstaaten: **DE**

(71) Anmelder: **N.V. Philips' Gloeilampenfabrieken**
**Groenewoudseweg 1**
**NL-5621 BA Eindhoven(NL)**

(84) Benannte Vertragsstaaten: **FR GB IT**

(72) Erfinder: **Draheim, Peter, Dr.**
**Goldmariekenweg 32**
**D-2000 Hamburg 61(DE)**

(72) Erfinder: **Demmer, Walter Heinrich**
**Sorthmannweg 15**
**D-2000 Hamburg 54(DE)**

(72) Erfinder: **Warmuth, Leo**
**Osterstrasse 156**
**D-2000 Hamburg 19(DE)**

(74) Vertreter: **Hartmann, Heinrich, Dipl.-Ing. et al,**
**Philips Patentverwaltung GmbH Billstrasse 80 Postfach 10 51 49**
**D-2000 Hamburg 28(DE)**

(54) **Schaltungsanordnung zum Umwandeln eines analogen Bildsignals in ein amplitudendiskretes Ausgangssignal.**

(57) In einer Schaltungsanordnung zum Umwandeln eines analogen Bildsignals, das aufeinanderfolgenden Halbbildern entspricht, in ein amplitudendiskretes Ausgangssignal, die in einer Vergleichsstufe das Bildsignal mit einer Anzahl von Referenzwerten vergleicht und an einem Ausgang ein amplitudendiskretes Zwischensignal erzeugt, wird eine wesentliche Vereinfachung des Schaltungsaufwandes bei gleichzeitiger Verbesserung der Fehlerunterdrückung dadurch erreicht, daß die Veränderung der Lage der Werte des Bildsignals und der Referenzwerte zueinander der Summe aus einem Bruchteil und einer ersten ganzen Zahl von Wertintervallen entspricht.

18
8
14
9
12
15
16
17
11
3
10
13
1
5
2
4
19
25
22
26
28
7
21
27
24
20
23
6
+
Fig.1

EP 0 118 960 A2

Croydon Printing Company Ltd.

Schaltungsanordnung zum Umwandeln eines analogen Bildsignals in ein amplitudendiskretes Ausgangssignal

Die Erfindung bezieht sich auf eine Schaltungsanordnung zum Umwandeln eines analogen Bildsignals, das aufeinanderfolgenden Halbbildern entspricht, in ein amplitudendiskretes Ausgangssignal, mit einer Vergleichsstufe, die das Bildsignal mit einer Anzahl von gleich beabstandeten Referenzwerten vergleicht, die zwischen sich Wertintervalle einschließen, und die an einem Ausgang ein amplitudendiskretes Zwischensignal erzeugt, das das Wertintervall angibt, in dem der Wert des Bildsignals liegt, wobei die Lage des Bildsignals einerseits und der Referenzwerte andererseits relativ zueinander um ein Bruchteil eines Wertintervalles periodisch verändert wird, und mit einer Mittelungseinrichtung, die das Zwischensignal erhält und die einen dem aus dem Mittelwert der Zwischensignalwerte einander entsprechender Bildpunkte gebildeten amplitudendiskreten Ausgangssignal entsprechenden optischen Wert auf einer Bildwiedergabeanordnung erzeugt.

Aus der DE-OS 30 15 141 ist ein Farbfernsehempfänger mit einem Analog-Digital-Wandler bekannt, an dessen Analog-Eingang ein Farb-Bild-Austast-Sychron-Signalgemisch (FBAS-Signal) liegt und der aus dessen Amplitude ein Parallelbinärwort als Ausgangssignal bildet. Das Ausgangssignal wird u.a. einer Schieberegisteranordnung zugeführt, die eine Verzögerung von der Dauer einer Zeile des Farbfernsehbildes aufweist. Der Farbfernsehempfänger enthält weiterhin eine Binärrechenstufe, die den arithmetischen Mittelwert aus dem Eingangs- und dem Ausgangssignal der Schieberegisteranordnung bildet. Wegen der hohen zu verarbeitenden Frequenzen ist der Analog-Digital-Wandler als ein Parallel-Analog-Digi-

tal-Wandler ausgebildet. Um bei einem derartigen Analog-Digital-Wandler eine Reduzierung des Aufwands auf die Hälfte zu erzielen, ohne die digitale Auflösung zu beeinträchtigen, ist für die Dauer jeder zweiten Zeile entweder die dem Analog-Digital-Wandler zugeführte Referenzspannung oder das Eingangssignal um eine dem Betrag eines halben Bits des Parallelbinärwortes entsprechende Spannung verschoben, wenn das höchste darstellbare Parallelbinärwort der Referenzspannung entspricht.

Grundsätzlich liegt der bekannten Anordnung offensichtlich die Erkenntnis zugrunde, daß die digitale Auflösung eines Analog-Digital-Wandlers, in dem ein analoges Signal, z.B. ein analoges Bildsignal, mit einer Anzahl von gleich beabstandeten Referenzwerten verglichen wird, dadurch erhöht werden kann, daß das analoge Signal in mehreren aufeinanderfolgenden (Vergleichs-)Schritten mit den Referenzwerten verglichen wird, daß zwischen jeweils zwei dieser Schritte entweder die Referenzwerte ohne Veränderung ihres gegenseitigen Abstandes oder das analoge Signal um einen Teil des Wertintervalls zwischen zwei Referenzwerten verschoben werden und daß die in den jeweiligen Schritten erhaltenen amplitudendiskreten Zwischensignale gemittelt werden. Beispielsweise kann ein Wert des analogen Signals in zwei Schritten mit den Referenzwerten verglichen werden, wobei zwischen den beiden Schritten das analoge Signal und die Referenzwerte gegeneinander um ein halbes Wertintervall verschoben werden. Bildet man dann den Mittelwert der in den beiden Schritten erhaltenen Werte des amplitudendiskreten Zwischensignals, kann daraus eine Angabe darüber entnommen werden, ob der Wert des analogen Signals in der unteren oder in der oberen Hälfte des betreffenden Wertintervalls liegt. Werden die Referenzwerte oder die Wertintervalle mit einer Binärzahl fortlaufend numeriert, ist die beschriebene Halbierung des Wertintervalls gleichbedeutend einer Erweiterung der Binärzahl um eine Stelle bzw. gleichbedeutend einer Verdoppelung der Auflösung des Analog-Digital-Wandlers. In gleicher Weise ist auch eine feinere Unterteilung der Wertintervalle möglich, wenn nämlich die Zahl der zu einem Wert des analogen Signals ausgeführten Schritte vergrößert und die Verschiebung zwischen dem analogen Signal einerseits und den Referenzwerten andererseits entsprechend verfeinert wird. Allgemein werden zu einem Wert des analogen Signals eine (zweite) ganze Zahl von Vergleichsschritten ausgeführt; zwischen je zwei dieser Vergleichsschritte werden das analoge Signal und die Referenzwerte um einen Betrag gegeneinander verschoben, der einem Bruchteil eines Wertintervalls, insbesondere einem Wertintervall multipliziert mit dem Kehrwert dieser (zweiten) ganzen Zahl, entspricht.

Auf diese Weise ist grundsätzlich eine beliebig feine Unterteilung der Wertintervalle des Analog-Digital-Wandlers möglich. Mit einem einfach aufgebauten Analog-Digital-Wandler, dessen Referenzwerte durch verhältnismäßig große Wertintervalle beabstandet sind, läßt sich auf diese Weise letztendlich eine sehr feine Auflösung erzielen. Nachteilig ist dabei außer der mit der zunehmenden Zahl von Vergleichsschritten anwachsenden Gesamtdauer für die Digitalisierung eines analogen Signals die Tatsache, daß die Ergebnisse aller Vergleichsschritte zwischengespeichert und mit einem aufwendigen Rechenwerk miteinander verknüpft werden müssen. Auch ist zur Beschleunigung des gesamten Ablaufs eine relativ hohe Umschaltfrequenz für das Verschieben der Referenzwerte bzw. des analogen Signals notwendig, die Einschwingvorgänge hervorrufen und damit das Ergebnis der Analog-Digital-Wandlung verfälschen kann.

Die aus der DE-OS 30 15 141 bekannte Schaltungsanordnung hat somit den Nachteil, daß Referenzspannung oder Eingangssignal mit relativ hoher Umschaltfrequenz verschoben werden. Da hierbei analoge Signale verarbeitet werden und eine sehr genaue Einstellung der jeweils erwünschten Spannungen erforderlich ist, benötigt man hierfür, beispielsweise zum Unterdrücken von Überschwingern, sehr aufwendige Schaltungsanordnungen.

Aus der DE-OS 28 43 706 ist nun eine Vergleichsstufe der eingangs genannten Art bekannt, bei der die Lage der Referenzwerte für die ungeradzahligen Halbbilder um die Hälfte des Abstandes zwischen zwei benachbarten Referenzwerten gegenüber der Lage der Referenzwerte für die geradzahligen Halbbilder verändert wird. Dadurch ist die Umschaltfrequenz für das Verschieben der Referenzspannung gegenüber dem Eingangssignal auf die Halbbildwechselfrequenz reduziert.

Ein weiterer Nachteil der aus der DE-OS 30 15 141 bekannten Schaltungsanordnung besteht darin, daß sich Fehler im Analog-Digital-Wandler sehr störend bemerkbar machen. So kann es vorkommen, daß ein Referenzwert eine falsche Lage einnimmt. Insbesondere bei der Darstellung einer Fläche leicht variierender Helligkeit oder Farbe auf der Bildwiedergabeanordnung entstehen durch einen derartigen Fehler durchgehende, senkrechte Farb- oder Helligkeitssprünge.

Demgegenüber hat die Erfindung die Aufgabe, eine Schaltungsanordnung der eingangs genannten Art zu schaffen, die einerseits den Einsatz eines vereinfachten Parallel-Analog-Digital-Wandlers ohne Einschränkungen der erwünschten digitalen Auflösung ermöglicht, ohne daß an anderer Stelle der Schaltungsanordnung ein zusätzlicher Schaltungsaufwand erforderlicht ist, bei gleichzeitiger Verbesserung der Unterdrückung von Fehlern bei der Analog-Digital-Wandlung.

Die Aufgabe wird nach der Erfindung dadurch gelöst, daß die Veränderung der Lage der Werte des Bildsignals und der Referenzwerte zueinander der Summe aus dem Bruchteil und einer ersten ganzen Zahl von Wertintervallen entspricht.

Bei einem Bildsignal, das einer Folge von Bildpunkten entspricht, kann anstelle einer Ausführung mehrerer Vergleichsschritte mit dem Wert des Bildsignals zu einem Bildpunkt die Tatsache ausgenutzt werden, daß benachbarte Bildpunkte - in einer Zeile hintereinanderliegend oder in zwei benachbarten Zeilen nebeneinanderliegend - in Helligkeit und Farbe nur sehr wenig voneinander abweichen, und es kann deshalb so verfahren werden, daß zu jedem Bildpunkt nur ein Vergleichsschritt ausgeführt und anschließend über benachbarte Bildpunkte gemittelt wird, was die Folgefrequenz der Vergleichsschritte und damit der Verschiebungen des analogen Bildsignals und der Referenzwerte gegeneinander in Grenzen hält.

Nach der Erfindung wird die Lage der Werte des Bildsignals relativ zu den Referenzwerten zwischen zwei Vergleichsschritten zusätzlich zu der beschriebenen Verschiebung um eine (erste ganze) Zahl von Wertintervallen verändert. Durch diese Maßnahme ist bei sonst unveränderter Funktion der erfindungsgemäßen Anordnung eine Verbesserung der Unterdrückung von Fehlern im Analog-Digital-Wandler erreicht, insbesondere von Fehlern, die durch eine falsche Lage eines Referenzwertes auftreten und die, wie oben beschrieben, zu durchgehenden, senkrechten Farb- oder Helligkeitssprüngen führen. Wird, wie im Stand der Technik, zwischen zwei aufeinander folgenden Zeilen oder Halbbildern die Lage der Referenzwerte gegenüber den Werten des Bildsignals nur um einen Bruchteil eines Wertintervalles zwischen zwei Referenzwerten verschoben, bleiben die Stellen, an denen sich diese Fehler im Bild bemerkbar machen, noch im wesentlichen an der gleichen Stelle. Damit bleiben die durchgehenden, senkrechten Farb- oder Helligkeitssprünge weiterhin erhalten. Wird dagegen erfindungsgemäß die Lage der Werte des Bildsignals relativ zu den Referenzwerten um zusätzlich ein oder mehrere Wertintervalle verschoben, kommt der genannte Helligkeits- bzw. Farbsprung in jeder Zeile des Bildes an einer anderen Stelle zu liegen und verwischt sich dadurch im gesamten Bildeindruck.

Es zeigt sich nun, daß bei der Digitalisierung eines Bildsignals, insbesondere eines Farbfernsehbildsignals, wesentliche Vereinfachungen und Verbesserungen aus der Tatsache entwickelt werden können, daß das Bildsignal aufeinanderfolgenden Halbbildern entspricht, die einander zeilensequentiell überlagert sind. Dadurch werden einander entsprechende Bildpunkte aufeinanderfolgender Halbbilder stets an einander benachbarten Stellen des Bildes zu liegen kommen. Die Mittelung über jeweils einander benachbarte Bildpunkte läßt sich somit durch eine Mittelung über einander entsprechende Bildpunkte aufeinanderfolgender Halbbilder ausführen. Die Lage der Werte des analogen Bildsignals wird dabei relativ zu den Referenzwerten nach einer weiteren Ausgestaltung der Erfindung lediglich jeweils zwischen zwei Halbbildern gegeneinander verschoben. Da die Halbbildfrequenz üblicher Bildsignale sehr niedrig und ihre Vertikalaustastlücke relativ groß ist, ist es ohne besonderen Schaltungsaufwand möglich, das analoge Bildsignal oder die Referenzwerte zwischen zwei Halbbildern zu verschieben, ohne auf der Bildwiedergabeanordnung sichtbare Einschwingvorgänge auszulösen. Die Verschiebung kann unmittelbar von den Vertikal-Sychronimpulsen des Bildsignals gesteuert werden.

Die Veränderung der Lage der Werte des Bildsignals relativ zu den Referenzwerten zwischen je zwei Halbbildern hat noch einen weiteren Vorteil. Da in einem ersten Halbbild die ungeraden Zeilen und in einem zweiten Halbbild die geraden Zeilen des ganzen Bildes übertragen werden, ist bei der Schaltungsanordnung nach der DE-OS 30 15 141 die Lage der Referenzwerte relativ zum analogen Bildsignal für die erste Zeile gegenüber der Lage der Referenzwerte relativ zum analogen Bildsignal für die dritte Zeile und diese wiederum gegenüber der Lage der Referenzwerte relativ zum analogen Bildsignal für die fünfte Zeile usw. verschoben. Analog werden im zweiten Halbbild die Referenzwerte für die zweite Zeile relativ zum analogen Bildsignal gegenüber denen für die vierte Zeile usw. verschoben sein. Im gesamten Bild ist dadurch die Lage der Referenzwerte relativ zum analogen Bildsignal für jeweils zwei benachbarte Zeilen einander gleich. Durch eine derartige Paarbildung werden jeweils zwei benachbarte Zeilen zusammen stärker hervorgehoben und die Mittelung über Zeilen mit unterschiedlicher Lage der Referenzwerte relativ zum analogen Bildsignal erschwert. Beim Verschieben der Referenzwerte gegenüber dem analogen Bildsignal jeweils zwischen zwei Halbbildern haben jedoch alle Zeilen eines Halbbildes untereinander gleiche Referenzwerte. Im gesamten Bild haben dadurch jeweils zwei benachbarte Zeilen gegeneinander verschobene Referenzwerte. Dadurch wird die Mittelung verbessert.

Bei den bisher beschriebenen Schaltungsanordnungen wird zum Mitteln der amplitudendiskreten Zwischensignale, z.B. wenn deren Werte als Parallelbinärworte vorliegen, im Gegenzug zur Verringerung des Aufwandes im Analog-Digital-Wandler eine sehr umfangreiche Schieberegisteranordnung und eine Binärrechenstufe vorgesehen werden müssen. Durch diese Maßnahmen kann der gesamte Schaltungsaufwand ungünstigenfalls erhöht und nicht verringert werden, da die Schieberegisteranordnung, die jeweils alle Parallelbinärworte einer Fernsehbildzeile oder eines Halbbildes speichern muß, sehr aufwendig ist.

Daher wird nach einer weiteren Ausgestaltung der Erfindung das Zwischensignal der Bildwiedergabeanordnung zugeführt und durch Überlagern wenigstens einer Anzahl von Halbbildern, die gleich dem Betrag der zweiten ganzen Zahl ist, in der die Mittelungseinrichtung bildenden Bildwiedergabeanordnung gemittelt.

Es wurde bereits beschrieben, daß das Bildsignal aufeinanderfolgenden, zeilensequentiell überlagerten Halbbildern entspricht. Dadurch können einander entsprechende Bildpunkte aufeinanderfolgender Halbbilder unmittelbar in der Bildwiedergabeanordnung einander überlagert werden. Die Über-

lagerung bewirkt eine Mittelung der Helligkeiten der einzelnen Bildpunkte. Nach der Erfindung wird somit die eine Erhöhung der digitalen Auflösung erzielende Mittelung zwischen zwei benachbarten Bildpunkten zweier benachbarter Zeilen erst bei der Darstellung des Bildes auf der Bildwiedergabeanordnung ausgeführt. Dadurch können gesonderte Vorrichtungen, wie sie insbesondere beim Stand der Technik zur elektrischen Überlagerung und Mittelung der den einzelnen Bildpunkten entsprechenden Werte des Bildsignals vorhanden sind, entfallen, wodurch eine wesentliche Vereinfachung des gesamten Schaltungsaufbaus erreicht wird. Bei einer derartigen Ausgestaltung der Erfindung werden die Werte des amplitudendiskreten Ausgangssignals unmittelbar als optische Werte in der Bildwiedergabeanordnung erzeugt.

Nach der Erfindung ist es ferner möglich, einander entsprechende Bildpunkte aus mehr als zwei Halbbildern, d.h. insbesondere aus zwei oder mehreren aufeinanderfolgenden Bildern, einander zu überlagern. Dabei wird die Tatsache ausgenutzt, daß einander entsprechende Bildpunkte zweier aufeinanderfolgender Bilder sich in der Regel nur wenig unterscheiden. Für eine derartige, mit einer "Mittelung in der Tiefe der Zeit" ausgeführten Erhöhung der Auflösung kann vorteilhaft eine Bildwiedergabeanordnung mit Speichereigenschaften eingesetzt werden, beispielsweise eine Bildröhre mit stärker nachleuchtendem Bildschirm.

Für den Fall, daß eine Schaltungsanordnung der eingangs genannten Art bereits zu anderen Zwecken eine Speicheranordnung zum Zwischenspeichern wenigstens eines Halbbildes umfaßt, läßt sich eine derartige Speicheranordnung in Verbindung mit einer Mittelungseinrichtung zum Überlagern von Halbbildern auch vor dem Zuführen des Zwischensignals zur Bildwiedergabeanordnung einsetzen.

Nach einer Ausgestaltung der Erfindung entspricht jeder Bruchteil eines Wertintervalls dem Kehrwert der zweiten ganzen Zahl von Wertintervallen. Die Wertintervalle des Analog-Digital-Wandlers werden dann in gleiche Teile unterteilt.

Nach einer Weiterbildung der Erfindung ist die erste ganze Zahl wenigstens gleich Zwei entsprechend einer zusätzlichen Veränderung der Lage der Werte des Bildsignals relativ zu den Referenzwerten um mindestens zwei Wertintervalle. Dadurch wird ein hinreichend breites Verwischen der beschriebenen Fehler im Analog-Digital-Wandler über die Helligkeits- bzw. Farbstufungen und damit auch über die Bildfläche erzielt.

Nach einer anderen Ausgestaltung der Erfindung wird die Mittelung über eine gerade Anzahl von Halbbildern ausgeführt. Insbesondere wird die Mittelung über zwei Halbbilder ausgeführt. Dadurch ist gewährleistet, daß in definierter Weise der Inhalt mehrerer aufeinanderfolgender Bilder oder insbesondere innerhalb eines Bildes gemittelt wird.

Nach einer weiteren Ausgestaltung der Erfindung wird der Wert des Zwischensignals vor Ausführen der Mittelung um ein der zugehörigen Veränderung der relativen Lage von Bildsignal und Referenzwerten entsprechendes, amplitudendiskretes Korrektursignal gleichsinnig zur Veränderung der Lage der Referenzwerte in bezug auf das Bildsignal verändert.

Beispielsweise beim Überlagern eines ersten und eines zweiten Halbbildes eines Farbfernsehsignals liegen die einander entsprechenden, zu überlagernden Bildpunkte unmittelbar neben- und nicht übereinander und werden erst durch den optischen Eindruck insbesondere auf das menschliche Auge zu einem Punkt resultierender Leuchtdichte kombiniert. Wird nun, wie oben beschrieben, zwischen den beiden Halbbildern die Lage der Werte des Bildsignals relativ zu den Referenzwerten um mehrere Wertintervalle verändert, ergibt sich zwischen den Bildpunkten des ersten und des zweiten Halbbildes ein größerer Leuchtdichteunterschied, der ggf. beim Betrachten des Bildes auf der Bildwiedergabeanordnung als zeilenrasterförmiger Kontrast wahrgenommen wird.

Es ist daher zweckmäßig, durch Hinzufügen eines amplitudendiskreten Korrektursignals zum Zwischensignal die vor der Analog-Digital-Wandlung eingeführte Veränderung der Lage der Werte des Bildsignals relativ zu den Referenzwerten wieder zu kompensieren derart, daß der Leuchtdichteunterschied benachbarter Bildpunkte verschiedener Halbbilder maximal einem Wertintervall entspricht. Das bedeutet, daß die aufeinanderfolgenden Halbbildern entsprechenden Werte des Zwischensignals die gleichen sind wie in dem Fall, in dem die erste ganze Zahl gleich Null gewählt wird und somit die Lage der Werte des Bildsignals relativ zu den Referenzwerten zwischen den beiden Halbbildern nur um den Bruchteil des Wertintervalls verändert wird, mit einer Ausnahme: Beim Ausfall eines Referenzwertes werden die dadurch auftretenden vergrößerten Sprünge in der Helligkeit, die sich, wie bereits beschrieben, insbesondere bei der Darstellung einer Fläche mit sich in Zeilenrichtung langsam und stetig ändernder Helligkeit störend bemerkbar machen, weiterhin von Zeile zu Zeile um die erste ganze Zahl von Wertintervallen gegeneinander versetzt und damit im dargestellten Bild verwischt.

Nach einer Weiterbildung der Erfindung wird das Korrektursignal aus der durch die Veränderung der relativen Lage von Bildsignal und Referenzwerten hervorgerufenen Veränderung des Zwischensignals gebildet und in einer an sich bekannten Klemmschaltung mit dem Zwischensignal verknüpft. Das Korrektursignal wird dabei unmittelbar aus dem Zwischensignal abgeleitet, wodurch sich eine besonders einfache Anpassung des Korrektursignals an die jeweiligen Veränderungen des Zwischensignals ergibt.

Nach einer anderen Weiterbildung der Erfindung umfaßt das Korrektursignal eine Anzahl fest vorgegebener Werte entsprechend der Veränderung der relativen Lage von Bildsignal und Referenzwerten, die gemäß dieser Veränderung umgeschaltet werden. Nimmt das Korrektursignal bei der bestimmungsgemäßen Umwandlung von Bildsignalen in der Schaltungsanordnung nur wenige bestimmte Werte ein, ist durch diese Weiterbildung eine einfache Möglichkeit der Erzeugung des Korrektursignals gegeben.

Das Hinzufügen des amplitudendiskreten Korrektursignals zum Zwischensignal kann beispielsweise auch durch eine mit der gleichen Frequenz gesteuerte Addiererschaltung erfolgen. Dabei wird ein vorteilhafter Kompromiß dadurch erhalten, daß der Wert der ersten ganzen Zahl gleich Zwei gesetzt wird. Bei einer höheren Veränderung der Lage der Werte des Bildsignals relativ zu den Referenzwerten würde nämlich der Wertebereich für das amplitudendiskrete Zwischensignal unnötig erweitert werden, während bei einer geringeren Veränderung die beschriebenen Störungen nicht genügend überdeckt werden könnten.

Nach einer weiteren Fortbildung der Erfindung wird zur Veränderung der Lage der Referenzwerte und des Bildsignals zueinander dem Bildsignal ein zwischen jeweils zwei Halbbildern wechselndes Veränderungssignal überlagert. Die Referenzwerte können dann fest gewählt werden, und dem Bildsignal wird vorzugsweise ein analoges, rechteckförmiges, halbbildfrequentes Signal zugefügt.

Nach einer anderen Ausgestaltung der Erfindung wird zur Veränderung der Lage der Referenzwerte und des Bildsignals zueinander den Referenzwerten ein zwischen jeweils zwei Halbbildern wechselndes Veränderungssignal überlagert. In diesem Fall wird der Verlauf des analogen Bildsignals nicht beeinflußt. Die Referenzwerte werden vorteilhaft aus verschiedenen Referenzquellen abgeleitet, die abwechselnd im Takt der Halbbildfrequenz mit der Vergleichsstufe verbindbar sind.

Nach einer Weiterbildung der Erfindung sind die Referenzwerte durch Spannungswerte dargestellt und wird zum Verändern der Lage der Referenzwerte jedem Spannungswert eine bestimmte, einstellbare bzw. umschaltbare Vorspannung überlagert. Die Referenzwerte lassen sich so auf einfache Weise aus einem leicht realisierbaren Spannungsnormal ableiten.

Eine besonders einfache und vorteilhafte Ausgestaltung der Erfindung ergibt sich dadurch, daß die als Referenzwerte dienenden Spannungswerte aus den Abgriffen einer Widerstandskette abgeleitet werden, deren Enden jeweils eine einstellbare bzw. umschaltbare Spannung zugeführt wird. Dadurch ist eine einfache, genaue und stabile Festlegung der Referenzwerte einerseits und eine ebenso vorteilhafte Veränderung derselben andererseits erzielbar.

Eine besonders einfache Ableitung der Referenzwerte aus einem Spannungsnormal ergibt sich nach einer vorteilhaften Weiterbildung der Erfindung dadurch, daß weitere Widerstände vorgesehen sind, die jeweils mit einem ihrer Anschlüsse mit je einem Ende der Widerstandskette und mit ihrem jeweils anderen Anschluß mit den die Widerstandskette speisenden Spannungen verbunden sind, und daß diese Widerstände umschaltbar ausgebildet sind. Das Umschalten der Widerstände erfolgt nach der Erfindung im Takte der Halbbildfrequenz.

Die Erfindung wird im folgenden anhand einiger in der Zeichnung dargestellter Ausführungsbeispiele näher erläutert. Es zeigen

Fig. 1 ein Blockschaltbild zum Erläutern der Funktionsweise einer Schaltungsanordnung nach der Erfindung,

Fig. 2 ein etwas detaillierteres Schaltbild einer Vergleichsstufe und einer Anordnung zum Erzeugen veränderbarer Referenzwerte.

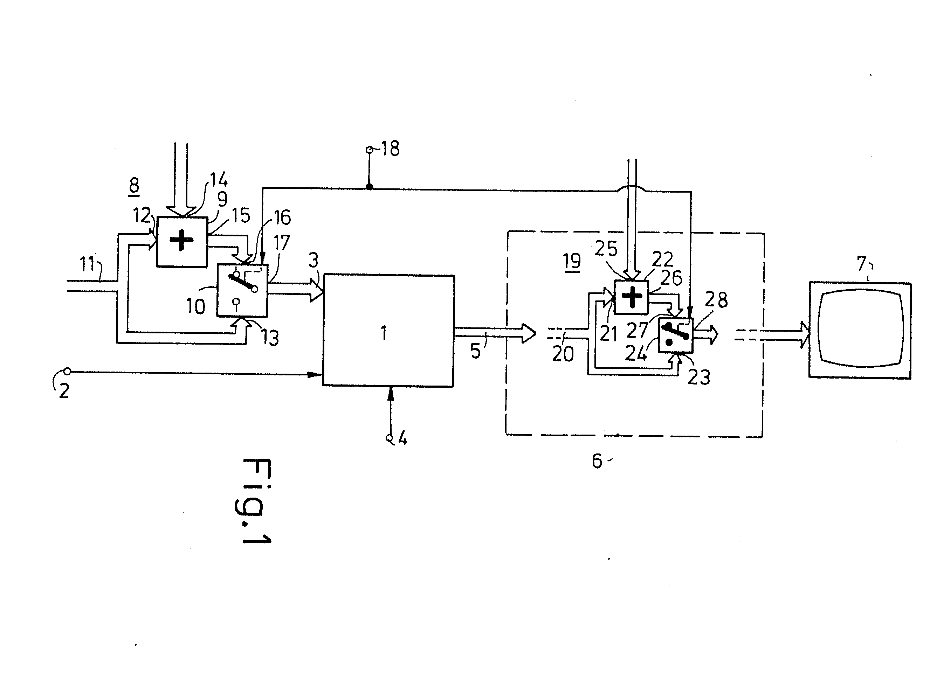

Fig. 1 zeigt ein Blockschaltbild zur schematischen Darstellung der Funktionsweise einer erfindungsgemäßen Schaltungsanordnung. Eine als Analog-Digital-Wandler ausgeführte Vergleichsstufe 1 weist einen ersten Eingang 2 auf, dem ein analoges Bildsignal zugeführt wird. Über einen zweiten Eingang 3 bzw. eine Anzahl derartiger Eingänge werden der Vergleichsstufe 1 ein oder mehrere Referenzwerte zugeführt. Die Vergleichsstufe weist ferner einen Eingang 4 zum Zuführen eines Abtasttaktsignals auf. Der Augenblickswert des der Vergleichsstufe 1 zugeführten analogen Bildsignals wird mit einer durch die Frequenz des Abtasttaktsignals bestimmten Folgefrequenz mit dem oder den am Eingang 3 zugeführten Referenzwerten verglichen. Das Ergebnis eines jeden Vergleichsschritts wird als ein Wert eines amplitudendiskreten Zwischensignals über einen Ausgang 5 aus der Vergleichsstufe 1 abgeleitet und über eine Anordnung 6, die einer weiteren Signalbearbeitung dient, einer Bildwiedergabeanordnung 7 zugeführt, in der die Werte des Zwischensignals zu einem einem Wert eines amplitudendiskreten Ausgangssignals entsprechenden optischen Wert überlagert werden. Als weitere Signalbearbeitung sind insbesondere Filterung, Farbaufteilung und dgl. vorgesehen. Wird das amplitudendiskrete Zwischensignal in der Form eines Parallelbinärwortes abgegeben, werden die genannten weiteren Signalbearbeitungen bevorzugt digital durchgeführt.

Zum Erzeugen der Veränderung der Lage der Referenzwerte relativ zu den Werten des Bildsignals zwischen je zwei Halbbildern ist dem zweiten Eingang bzw. den zweiten Eingängen 3 der Vergleichsstufe 1 eine Anordnung 8 vorgeschaltet, die aus einer ersten Additionsvorrichtung 9 und einer ersten Umschaltvorrichtung 10 besteht. Der bzw. die Referenzwerte werden über eine Leitung 11 einem ersten Eingang 12 der ersten Additionsvorrichtung und einem ersten Eingang 13 der ersten Umschaltvorrichtung zugeführt. Über einen zweiten Eingang 14 wird der ersten Additionsvorrichtung ein die Veränderung der Lage der Referenzwerte bestimmendes Signal zugeführt. Dieses Signal wird in der ersten Additionsvorrichtung 9 zu dem bzw. den Referenzwerten addiert und über einen Ausgang 15 der ersten Additionsvorrichtung 9 einem zweiten Eingang 16 der ersten Umschaltvorrichtung 10 zugeleitet. Die erste Umschaltvorrichtung 10 weist weiterhin einen Ausgang 17 auf, der im Takt der Halbbildfrequenz abwechselnd mit dem ersten Eingang 13 und dem zweiten Eingang 16 verbunden wird. Die erste Umschaltvorrichtung ist dazu weiterhin mit einer Taktleitung 18 verbunden, die ein halbbildfrequentes Taktsignal, beispielsweise Halbbildwechselimpulse, führt. Auf diese Weise werden die Referenzwerte durch die Anordnung 8 für jedes zweite Halbbild gemäß einem dem zweiten Eingang der ersten Additionsvorrichtung zugeführten Signal verändert. Die beschriebene Schaltungsanordnung dient somit bevorzugt zum Überlagern zweier Halbbilder, ist jedoch auch für die oben genannte "Mittelung in der Tiefe der Zeit" verwendbar.

Die Schaltungsanordnung enthält ferner innerhalb der Anordnung 6 zur weiteren Signalbearbeitung eine in ihrer Funktionsweise der Anordnung 8 entsprechende Anordnung 19, mit der der Wert des amplitudendiskreten Zwischensignals mit einem der Veränderung der Referenzwerte entsprechenden Korrektursignal beaufschlagt wird. Dazu wird das Zwischensignal über eine Leitung 20 einerseits einem ersten Eingang 21 einer zweiten Additionsvorrichtung 22 und andererseits einem ersten Eingang 23 einer zweiten Umschaltvorrichtung 24 zugeführt. Das Korrektursignal wird einem zweiten Eingang 25 der zweiten Additionsvorrichtung 22 zugeführt. Am Ausgang 26 der zweiten Additionsvorrichtung 22 wird das mit dem Korrektursignal beaufschlagte Zwischensignal abgeleitet und einem zweiten Eingang 27 der zweiten Umschaltvorrichtung 24 zugeleitet. Die zweite Umschaltvorrichtung 24 erhält weiterhin über die Taktleitung 18 das halbbildfrequente Taktsignal zugeleitet, durch das ihr Ausgang 28 von Halbbild zu Halbbild abwechselnd mit ihrem ersten Eingang 23 und ihrem zweiten Eingang 27 verbunden wird. Auf diese Weise wird für jedes zweite Halbbild ein mit dem Korrektursignal beaufschlagtes Zwischensignal erhalten und der weiteren Signalbearbeitung und insbesondere der Bildwiedergabeanordnung 7 zugeführt.

Die Anordnung 19 zur Überlagerung des Korrektursignals kann grundsätzlich an jeder Stelle in den Signalweg des amplitudendiskreten Zwischensignals von der Vergleichsstufe 1 bis zur Bildwiedergabeanordnung 7 eingefügt werden. Das amplitudendiskrete Zwischensignal kann somit unmittelbar nach seiner Erzeugung als auch im Anschluß an Filterung, Farbaufteilung und dgl. korrigiert werden.

Die Anordnungen 8 und 19 zur Veränderung der Referenzwerte und zur Überlagerung des Korrektursignals können als Analog- oder auch als Binärschaltungen ausgebildet sein. Beispielsweise wird die Anordnung 8 in analoger Technik ausgeführt sein, wenn die Referenzwerte der Vergleichsstufe 1 in analoger Form zugeführt werden, und wird die Anordnung 19 als Binärschaltung ausgebildet sein, wenn die Zwischensignale die Form von Parallelbinärworten aufweisen. Anstelle der beschriebenen Anordnungen 8 und 19 sind auch anders aufgebaute Anordnungen möglich, insbesondere auch für den Fall einer mehrfachen Veränderung der Lage der Referenzwerte. So kann anstelle der Anordnung 19 eine Klemmschaltung verwendet werden. Das Korrektursignal kann in Form fest vorgegebener Werte zugeführt oder unmittelbar aus den halbbildfrequenten Veränderungen des Zwischensignals gewonnen werden.

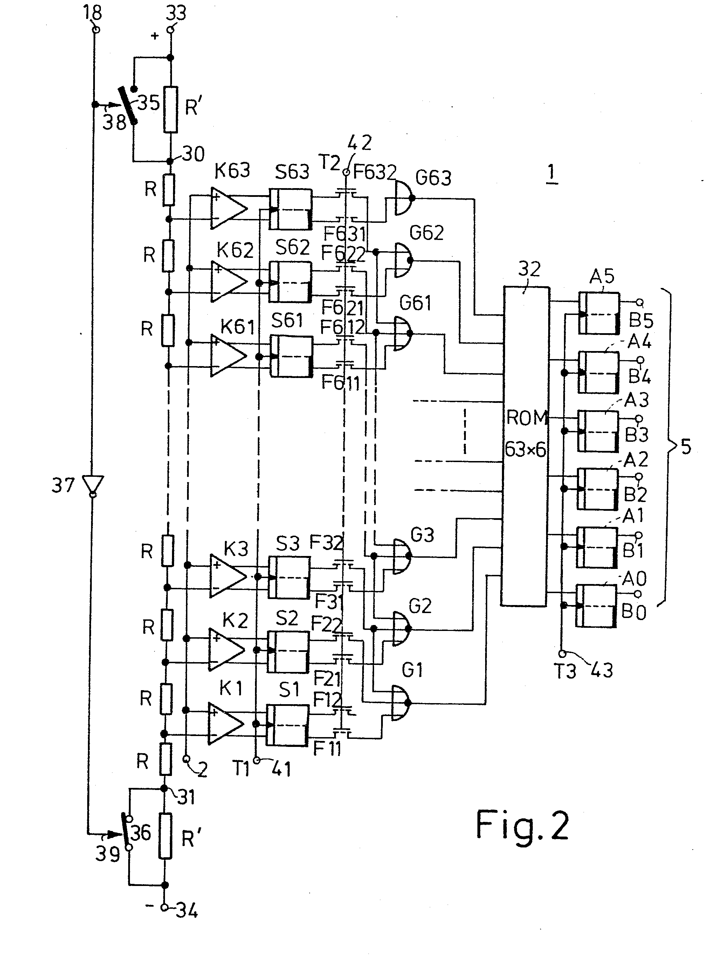

In Fig. 2 ist das Blockschaltbild eines Ausführungsbeispiels für eine Vergleichsstufe 1 dargestellt, die als Parallel-Analog-Digital-Wandler ausgebildet ist. Die Vergleichsstufe 1 wandelt den Augenblickswert des über ihren ersten Eingang 2 zugeführten analogen Bildsignals in einen Wert des amplitudendiskreten Zwischensignals um, das am Ausgang 5 in der Form eines sechsstelligen Parallelbinärwortes abgegeben wird. Die Vergleichsstufe 1 enthält 63 Komparatoren K1 bis K63, beispielsweise Differenzverstärker, deren nichtinvertierende Eingänge mit dem ersten Eingang 2 für das analoge Bildsignal verbunden sind. Die invertierenden Eingänge der Komparatoren K1 bis K63 sind der Reihe nach mit Abgriffen einer aus 64 gleichen Widerständen R bestehenden Widerstandskette, die ein erstes Ende 30 und ein zweites Ende 31 aufweist, verbunden. Die Widerstandskette liefert an ihren Abgriffen eine Anzahl gleich beabstandeter Referenzwerte, mit denen das über den Eingang 2 zugeführte analoge Bildsignal in den Komparatoren K1 bis K63 verglichen wird. Jeder der Komparatoren K1 bis K63 weist zwei Ausgänge auf, von denen jeweils der erste (in der Zeichnung nach Fig. 2 der obere) ein Eins-Signal liefert, wenn der Augenblickswert des analogen Bildsignals größer als der zugehörige Referenzwert ist, und von denen der jeweils zweite (in der Zeichnung nach Fig. 2 jeweils der untere) dann ein Eins-Signal liefert, wenn der Augenblickswert des analogen Bildsignals kleiner ist als der zugehörige Referenzwert.

Die Ausgänge jedes der Komparatoren K1 bis K63 sind mit Eingängen jeweils einer von 63 Speicherzellen S1 bis S63 verbunden, in denen die jeweils von den Komparatoren K1 bis K63 abgegebenen Ausgangssignale zu dem Zeitpunkt gespeichert werden, in dem an die gemeinsam an einen ersten Abtastakteingang 41 geführten Steuereingänge der Speicherzellen ein erster Abtastimpuls T1 angelegt wird. In den Speicherzellen S1 bis S63 wird somit der Augenblickswert des analogen Bildsignals zu dem durch den an den ersten Abtasttakteingang 41 angelegten Abtastimpuls T1 festgelegten Zeitpunkt derart gespeichert, daß sich alle Speicherzellen, die mit Komparatoren verbunden sind, deren Referenzwerte größer als der Augenblickswert des analogen Bildsignals sind, in einem ersten Speicherzustand und alle übrigen Speicherzellen in einem zweiten Speicherzustand befinden. Die Speicherzellen S1 bis S63 geben in ihrem ersten Speicherzustand an ihrem ersten, jeweils unteren Ausgang ein Eins-Signal ab, während sie in ihrem zweiten Speicherzustand an ihrem zweiten, jeweils oberen Ausgang ein Eins-Signal abgeben.

Die Ausgangssignale der Speicherzellen S1 bis S63 werden über Feldeffekttransistoren F11 bis F632, deren Gateelektroden mit einem zweiten Abtasttakteingang 42 verbunden sind, Eingängen einer Anzahl von NOR-Gattern G1 bis G63 zugeführt. Dazu wird an den zweiten Abtasttakteingang 42 ein zweiter Abtastimpuls T2 angelegt, der zeitlich auf den ersten Abtastimpuls T1 folgt. Die NOR-Gatter G1 bis G63 sind derart mit den Ausgängen der Speicherzellen S1 bis S63 verbunden, daß nur jeweils einer der Ausgänge der NOR-Gatter G1 bis G63 ein Eins-Signal führt, und zwar der Ausgang des NOR-Gatters, das der Speicherzelle und damit dem Komparator zugeordnet ist, dessen zugehöriger Referenzwert der größte Referenzwert kleiner als der abgetastete Augenblickswert des analogen Bildsignals ist.

Die Ausgänge der NOR-Gatter G1 bis G63 sind mit einem Umsetzer 32 verbunden, der weiterhin 6 Ausgänge entsprechend den Stellen eines sechsstelligen Parallelbinärwortes aufweist. Diese Ausgänge sind jeweils mit dem Eingang eines von 6 Ausgangsregistern A0 bis A5 verbunden. Der Umsetzer 32 ist als ROM ausgebildet, beispielsweise in der Form einer Diodenmatrix mit 63 Eingängen und 6 Ausgängen, wobei die an den Ausgängen abgegebenen Parallelbinärworte eine kontinuierlich aufsteigende Folge von Binärzahlen bilden, wenn nacheinander an jeweils einem der Eingänge ein Signal angelegt wird, beginnend mit dem mit dem NOR-Gatter G1 verbundenen Eingang und endend mit dem mit dem NOR-Gatter G63 verbundenen Eingang. Mit einem dritten Abtastimpuls T3, dessen Vorderflanke zeitlich auf die Vorderflanke des zweiten Abtastimpulses T2 folgt und dessen Rückflanke zeitlich vor der Rückflanke des zweiten Abtastimpulses T2 liegt und der an den dritten Abtasttakteingang 43 gelegt ist, der alle Steuereingänge der Ausgangsregister A0 bis A5 verbindet, wird das vom Umsetzer 32 abgegebene Parallelbinärwort in den Ausgangsregistern A0 bis A5 gespeichert und steht dann an deren Ausgängen B0 bis B5, die den Ausgang 5 der Vergleichsstufe 1 bilden, als amplitudendiskretes Zwischensignal an.

Zum Zuführen einer umschaltbaren Referenzspannung an den Enden 30 und 31 der Widerstandskette sind diese über Widerstände R' mit den Polen 33 und 34 einer Referenzspannungsquelle verbunden. Die Widerstände R' haben bei dem hier beschriebenen Ausführungsbeispiel den 2,5-fachen Widerstandswert der Widerstände R der Widerstandskette entsprechend einer Veränderung der Referenzwerte zwischen je zwei Halbbildern um das 2,5-fache eines Wertintervalls. Durch Wahl anderer Widerstandswerte für R' lassen sich auf einfache Weise auch Veränderungen der Referenzwerte um beliebige andere Werte erzielen. Die Widerstände R' sind durch ihnen parallelgeschaltete Schaltelemente 35 und 36 wahlweise überbrückbar derart, daß jeweils eines der Schaltelemente 35, 36 leitend und das andere gesperrt ist. Dadurch wird bei der vorliegenden Schaltungsanordnung eine Verschiebung der Referenzwerte abwechselnd um 2,5 Wertintervalle nach oben und nach unten erreicht. Die Schaltelemente sind vorzugsweise als Halbleiterschalter, beispielsweise Feldeffekttransistoren ausgebildet. Ihre Steueranschlüsse 38, 39 sind über einen Inverter 37 miteinander verbunden. Der Steueranschluß 38 des Schaltelementes 35 ist weiterhin mit der Taktleitung 18 verbunden und erhält über diese das halbbildfrequente Taktsignal zugeführt.

PATENTANSPRÜCHE:

1. Schaltungsanordnung zum Umwandeln eines analogen Bildsignals, das aufeinanderfolgenden Halbbildern entspricht, in ein amplitudendiskretes Ausgangssignal, mit einer Vergleichsstufe, die das Bildsignal mit einer Anzahl von gleich beabstandeten Referenzwerten vergleicht, die zwischen sich Wertintervalle einschließen, und die an einem Ausgang ein amplitudendiskretes Zwischensignal erzeugt, das das Wertintervall angibt, in dem der Wert des Bildsignals liegt, wobei die Lage des Bildsignals einerseits und der Referenzwerte andererseits relativ zueinander um ein Bruchteil eines Wertintervalls periodisch verändert wird, und mit einer Mittelungseinrichtung, die das Zwischensignal erhält und die einen dem aus dem Mittelwert der Zwischensignalwerte einander entsprechender Bildpunkte gebildeten amplitudendiskreten Ausgangssignal entsprechenden optischen Wert auf einer Bildwiedergabeanordnung erzeugt,
dadurch gekennzeichnet, daß die Veränderung der Lage der Werte des Bildsignals und der Referenzwerte zueinander der Summe aus dem Bruchteil und einer ersten ganzen Zahl von Wertintervallen entspricht.

2. Schaltungsanordnung nach Anspruch 1,
dadurch gekennzeichnet, daß die Lage der Werte des Bildsignals relativ zu den Referenzwerten zwischen je zwei Halbbildern verändert wird.

3. Schaltungsanordnung nach Anspruch 1 oder 2,
dadurch gekennzeichnet, daß das Zwischensignal der Bildwiedergabeanordnung zugeführt und durch Überlagern wenigstens einer Anzahl von Halbbildern, die gleich dem Betrag der zweiten ganzen Zahl ist, in der die Mittelungseinrichtung bildenden Bildwiedergabeanordnung gemittelt wird.

4. Schaltungsanordnung nach Anspruch 3, dadurch gekennzeichnet, daß jeder Bruchteil eines Wertintervalls dem Kehrwert der zweiten ganzen Zahl von Wertintervallen entspricht.

5. Schaltungsanordnung nach Anspruch 1, dadurch gekennzeichnet, daß die erste ganze Zahl wenigstens gleich zwei ist.

6. Schaltungsanordnung nach Anspruch 1, 2, 3, 4 oder 5, dadurch gekennzeichnet, daß die Mittelung über eine gerade Anzahl von Halbbildern ausgeführt wird.

7. Schaltungsanordnung nach Anspruch 6, dadurch gekennzeichnet, daß die Mittelung über zwei Halbbilder ausgeführt wird.

8. Schaltungsanordnung nach einem der vorhergehenden Ansprüche, dadurch gekennzeichnet, daß der Wert des Zwischensignals vor Ausführen der Mittelung um ein der zugehörigen Veränderung der relativen Lage von Bildsignal und Referenzwerten entsprechendes, amplitudendiskretes Korrektursignal gleichsinnig zur Veränderung der Lage der Referenzwerte in bezug auf das Bildsignal verändert wird.

9. Schaltungsanordnung nach Anspruch 8, dadurch gekennzeichnet, daß das Korrektursignal aus der durch die Veränderung der relativen Lage von Bildsignal und Referenzwerten hervorgerufenen Veränderung des Zwischensignals gebildet und in einer an sich bekannten Klemmschaltung mit dem Zwischensignal verknüpft wird.

10. Schaltungsanordnung nach Anspruch 8, dadurch gekennzeichnet, daß das Korrektursignal eine Anzahl fest vorgegebener Werte entsprechend der Veränderung der relativen Lage von Bildsignal und Referenzwerten umfaßt, die gemäß dieser Veränderung umgeschaltet werden.

11. Schaltungsanordnung nach einem der vorhergehenden Ansprüche, dadurch gekennzeichnet, daß zur Veränderung der Lage der Referenzwerte und des Bildsignals zueinander dem Bildsignal ein zwischen jeweils zwei Halbbildern wechselndes Veränderungssignal überlagert wird.

12. Schaltungsanordnung nach einem der Ansprüche 1 bis 11, dadurch gekennzeichnet, daß zur Veränderung der Lage der Referenzwerte und des Bildsignals zueinander den Referenzwerten ein zwischen jeweils zwei Halbbildern wechselndes Veränderungssignal überlagert wird.

13. Schaltungsanordnung nach Anspruch 12, dadurch gekennzeichnet, daß die Referenzwerte durch Spannungswerte dargestellt sind und daß zum Verändern der Lage der Referenzwerte jedem Spannungswert eine bestimmte, einstellbare bzw. umschaltbare Vorspannung überlagert wird.

14. Schaltungsanordnung nach Anspruch 13, dadurch gekennzeichnet, daß die als Referenzwerte dienenden Spannungswerte aus den Abgriffen einer Widerstandskette abgeleitet werden, deren Enden jeweils eine einstellbare bzw. umschaltbare Spannung zugeführt wird.

15. Schaltungsanordnung nach Anspruch 14, gekennzeichnet durch weitere Widerstände, die jeweils mit einem ihrer Anschlüsse mit je einem Ende der Widerstandskette und mit ihrem jeweils anderen Anschluß mit den die Widerstandskette speisenden Spannungen verbunden sind, welche Widerstände umschaltbar ausgebildet sind.

Fig.1

Fig.2